# EUROPEAN PATENT APPLICATION

(11) **EP 4 253 346 A1**
(43) Date of publication of application: **04.10.2023**
(21) Application number: 21896141.5
(22) Date of filing: 23.04.2021
(51) Int. Cl.: C04B 35/26, C04B 35/622, H05K 9/00

(54) **FERRITE MATERIAL FOR ELECTROMAGNETIC ABSORPTION AND SHIELDING, AND ELECTROMAGNETIC WAVE ABSORBER AND PREPARATION METHOD THEREFOR**

(30) Priority: 30.11.2020 CN 202011384622
(71) Applicant: Hengdian Group DMEGC Magnetics Co., Ltd., Jinhua, Zhejiang 322118 (CN)
(72) Inventor: WANG, Chaoming, Jinhua, Zhejiang 322118 (CN); WANG, Kaiwang, Jinhua, Zhejiang 322118 (CN); ZHU, Yong, Jinhua, Zhejiang 322118 (CN); YAN, Zhengxin, Jinhua, Zhejiang 322118 (CN); LV, Feiyu, Jinhua, Zhejiang 322118 (CN)
(74) Representative: Cabinet Beaumont
(86) International application number: PCT/CN2021/089122
(87) International publication number: WO 2022/110626

(57) **Abstract**

Provided are a ferrite material for electromagnetic absorption and shielding, and an electromagnetic wave absorber and a preparation method therefor. The ferrite material comprises a main component and an auxiliary component; the main component comprises Fe₂O₃, ZnO, and MnO; and the auxiliary component comprises CuO, NiO, and Co₂O₃. The electromagnetic wave absorber is prepared from the ferrite material. The preparation method for the electromagnetic wave absorber comprises: weighing Fe₂O₃, Mn₃O₄, and ZnO; mixing said components with CuO, NiO, and Co₂O₃ for granulating and forming to obtain a blank; and performing thermal insulation and sintering on the blank. Since each component in the main component and the auxiliary component is specifically selected, and the proportion is optimized, the overall performance of the electromagnetic wave absorber is excellent, the magnetic permeability reaches 3500-6000 at 100 KHz, the reflection loss is remarkably reduced, and the frequency range of noise-absorbing electromagnetic waves is widened.

## Description

### TECHNICAL FIELD

The present application belongs to the technical field of magnetic materials, and relates to a ferrite material for electromagnetic wave absorption and shielding, an electromagnetic wave absorber and a preparation method thereof.

### BACKGROUND

Microwave darkroom is the key equipment and ideal site to perform experiments and tests about electromagnetic compatibility (EMC). Microwave darkroom is also known as shielding darkroom, electric wave darkroom, anechoic shielding chamber, etc. At present, there are mainly three types of absorbing materials used in EMC microwave darkroom: dielectric loss wave-absorbing materials, ferrite magnetic absorbing materials and composite wave-absorbing materials. Ferrite absorbers are directly attached to the metal wall of the shielding darkroom to maximize the low-frequency part absorption of electromagnetic wave. According to FCC and EU standards, the lower frequency limit for EMC testing is required to be 30 MHz, and thus the EMC microwave darkroom must provide acceptable test accuracy within this frequency range. The International Electrotechnical Commission (IEC) defines a uniform field requirement of frequency range down to 26 MHz for testing the radiation sensitivity of electronic equipment, so the low frequency performance of the microwave darkroom is very important, and the ferrite magnetic absorbing material therefore becomes the key to the quality of the microwave darkroom.

As the general principle of ferrite absorbing materials, when the magnetic permeability ui is more than 200, ui*fm is equal to 1.5 × 10⁵ MHz, where fm is the matching frequency of the ferrite electromagnetic wave absorber, and with the EMC test frequency standard lowering the frequency, the magnetic permeability ui of ferrite needs to be increased. When the EMC test frequency is at 30 MHz, the magnetic permeability of ferrite needs to be about 5000, and the magnetic permeability of nickel-zinc ferrite material is generally only less than 2000, so only manganese-zinc ferrite material can be used as the low-frequency wave-absorbing material. In order to achieve the best effect of absorbing electromagnetic wave by ferrite at certain frequency, the complex magnetic permeability u of the ferrite material should meet u=λ/(2πt), where λ is the wavelength of electromagnetic wave, t is the thickness of absorbing material. Therefore, there are some differences between the wave-absorbing manganese-zinc ferrite material at certain frequency and the conventional manganese-zinc ferrite material.

CN110845228A discloses an iron-poor soft magnetic ferrite which includes main components and auxiliary components, and by molar percentage, the main components include 46.0-49.9mol% Fe₂O₃, 21.0-26.0mol% ZnO and the remainder of MnO; based on a sum mass of the main components, the auxiliary components at least contain 500-2500 ppm of TiO₂ or 1000-5000 ppm of SnO₂.

CN105272194A discloses a nickel-zinc ferrite wave-absorbing material formulation, a powder and a preparation method thereof. The formulation includes main components and an additive. The main components are ferric oxide Fe₂O₃, zinc oxide ZnO and nickel oxide NiO, and weight percentage contents of the main components include: 64-70wt% of Fe₂O₃, 15-25wt% of ZnO, and 6-21wt% of NiO, based on a total weight percentage content of the main components being 100wt%; the additive is tantalum oxide and/or niobium oxide.

CN109688780B discloses a method of preparing an iron-silicon-aluminum electromagnetic wave absorber, which includes mixing and ball-milling manganese-zinc ferrite with an iron-silicon-aluminum alloy powder, where a material-to-ball ratio is 1:14-16, and the ball-milling time is 5-50 h, and then drying the product to obtain the iron-silicon aluminum electromagnetic wave absorber. The manganese-zinc ferrite is 0.5-5at% of the iron-silicon-aluminum electromagnetic wave absorber, and ratios of the manganese-zinc ferrite include: 52-55at% of Fe₂O₃, 33-36at% of MnO, and 10-14at% of ZnO.

However, the reflection loss of the current electromagnetic wave absorber is still high, and the electromagnetic wave absorption ability of the material is not ideal. Hence, there is an urgent need to optimize and improve the components and formulations.

### SUMMARY

An object of the present application is to provide a ferrite material for electromagnetic wave absorption and shielding, an electromagnetic wave absorber and a preparation method thereof. By peculiarly selecting each component in the main components and auxiliary components and optimizing the ratios in the present application, the overall performance of the prepared electromagnetic wave absorber is excellent, the magnetic permeability reaches 3500-6000 at 100 KHz and the reflection loss of the material significantly decreases, and meanwhile, the frequency range of the absorbed electromagnetic wave noise is extended.

To achieve the object, the present application adopts the technical solutions below.

In a first aspect, the present application provides a ferrite material for electromagnetic absorption and shielding, and the ferrite material includes main components and auxiliary components; the main components include Fe₂O₃, ZnO and MnO, and the auxiliary components include CuO, NiO and Co₂O₃.

The present application limits the auxiliary components to CuO, NiO and Co₂O₃. On the one hand, the effect of adding CuO is to reduce the sintering temperature for more integral grains and more compact product; on the other hand, Cu²⁺ can partially replace Mn ions in the lattice, thus improving the magnetic permeability and performance stability. The effect of adding NiO is to replace part of Mn ions, thus improving the saturation magnetic induction and sintering density of the material. The effect of adding Co₂O₃ is to replace Mn ions in the lattice; the Co ferrite has a large positive K1 value, the manganese zinc ferrite has a negative K1 value, and the appropriate addition has a compensating effect, thus reducing the magnetocrystalline anisotropy field and improving the magnetic permeability and cut-off frequency of the material. The three substances of the auxiliary components have synergetic effect to give the prepared electromagnetic wave absorber an excellent overall performance, in which the magnetic permeability reaches 3500-6000 at 100 KHz and the reflection loss of the material significantly decreases, and meanwhile, the frequency range of the absorbed electromagnetic wave noise is extended.

As an optional technical solution of the present application, based on a molar percentage of the main components being 100mol%, Fe₂O₃ is 44-46mol%, such as 44mol%, 44.2mol%, 44.6mol%, 44.8mol%, 45mol%, 45.2mol%, 45.4mol%, 45.6mol%, 45.8mol% or 46mol%, and ZnO is 20-24mol%, such as 20mol%, 20.5mol%, 21mol%, 21.5mol%, 22mol%, 22.5mol%, 23mol%, 23.5mol% or 24mol%; however, the molar percentage is not limited to the listed values, other unlisted values within the range are also applicable; the remainder is MnO.

Optionally, based on a mass fraction of the main components being 100wt%, the auxiliary components include 0-3wt% of CuO, 0-0.1wt% of NiO, and 0-1wt% of Co₂O₃; CuO may be 0.5wt%, 1.0wt%, 1.5wt%, 2.0wt%, 2.5wt% or 3.0wt%, NiO may be 0.01wt%, 0.02wt%, 0.03wt%, 0.04wt%, 0.05wt%, 0.06wt%, 0.07wt%, 0.08wt%, 0.09wt% or 0.1wt%, and the content of Co₂O₃ may be 0.1wt%, 0.2wt%, 0.3wt%, 0.4wt%, 0.5wt%, 0.6wt%, 0.7wt%, 0.8wt%, 0.9wt% or 1.0wt%; however, the mass fraction is not limited to the listed values, other unlisted values within the range are also applicable; and the contents of CuO, NiO and Co₂O₃ do not include 0.

By optimizing the ratios of each component in the auxiliary components in the present application, the overall performance of the prepared electromagnetic wave absorber is excellent, the magnetic permeability reaches 3500-6000 at 100 KHz and the reflection loss of the material significantly decreases, and meanwhile, the frequency range of the absorbed electromagnetic wave noise is extended. Specifically, the auxiliary components are limited to include 0-3wt% of CuO in the present application. The CuO addition of more than 3wt% will lead to abnormal grain growth and giant crystal formation, deteriorating the grain consistency and the material performance, which is resulted from the fact that CuO is a low melting point substance and prone to being sintered in liquid phase form with too much addition, accelerating the grain growth and causing abnormal grain growth. The auxiliary components are also limited to include 0-0. 1wt% of NiO in the present application. The NiO addition of more than 0. 1wt% will lead to a significant decrease in magnetic permeability, which is resulted from the fact that Ni⁺ occupies B-position in the lattice and reduces the ionic magnetic moment of B-position, leading to a significant decrease in magnetic permeability. The auxiliary components are also limited to include 0-1wt% of Co₂O₃ in the present application. The Co₂O₃ addition of more than 1wt% will lead to a significant decrease in magnetic permeability, which is resulted from the fact that Co ferrite has a large positive K1 and excessive addition will increase the K1 of the final ferrite, thus reducing the overall performance.

In the second aspect, the present application provides an electromagnetic wave absorber, and the electromagnetic wave absorber is prepared from the ferrite material according to the first aspect.

As an optional technical solution of the present application, the electromagnetic wave absorber has a magnetic permeability of 3500-6000 at 25°C, such as 3500, 4000, 4500, 5000, 5500 or 6000; however, the magnetic permeability is not limited to the listed values, other unlisted values within the range are also applicable.

Optionally, the electromagnetic wave absorber has a maximum reflection loss of -24 dB.

Optionally, the electromagnetic wave absorber has a best matching frequency of 25-50 MHz, such as 25 MHz, 30 MHz, 35 MHz, 40 MHz, 45 MHz or 50 MHz; however, the best matching frequency is not limited to the listed values, other unlisted values within the range are also applicable.

Optionally, the electromagnetic wave absorber has a sheet structure, and the electromagnetic wave absorber is provided with a through hole along the thickness direction at the center.

Optionally, the electromagnetic wave absorber has a thickness of 3-10 mm, such as 3 mm, 4 mm, 5 mm, 6 mm, 7 mm, 8 mm, 9 mm or 10 mm; however, the thickness is not limited to the listed values, other unlisted values within the range are also applicable.

In a third aspect, the present application provides a preparation method of the electromagnetic wave absorber according to the second aspect, and the preparation method includes:
weighing calculated amounts of Fe₂O₃, Mn₃O₄ and ZnO according to molar percentages of each component in the main components, mixing the main components with the auxiliary components including CuO, NiO and Co₂O₃ and performing prilling and molding to obtain a blank, and subjecting the blank to temperature-holding sintering to obtain the electromagnetic wave absorber.

As an optional technical solution of the present application, the preparation method specifically includes the following steps:
(I) weighing calculated amounts of Fe₂O₃, Mn₃O₄ and ZnO according to molar percentages of each component in the main components, performing sand-milling with water added, and performing spray prilling to obtain a spray material;
(II) pre-sintering the spray material, and performing second sand-milling with water added to obtain a sand-milling material, wherein the auxiliary components are added in specific ratios during the second sand-milling;
(III) adding PVA and a defoamer to the sand-milling material, performing second spray prilling to obtain particles, and molding the particles to obtain a blank;
(IV) subjecting the blank to temperature-holding sintering to obtain the electromagnetic wave absorber.

The preparation method provided by the present application adopts pre-sintering and second sand-milling. The pre-sintering allows various raw materials to react partially and convert to ferrite partially, which is conducive to the control of blank molding and sintering shrinkage; the role of second sand-milling is to make the particle size reach a certain distribution range, which is conducive to the uniform grain growth during the sintering process.

As an optional technical solution of the present application, in step (I), a time of the sand-milling is 50-70 min, such as 50 min, 52 min, 54 min, 56 min, 58 min, 60 min, 62 min, 64 min, 66 min, 68 min or 70 min; however, the time is not limited to the listed values, other unlisted values within the range are also applicable; optionally, the time is 60 min.

Optionally, before subjected to the spray prilling, a mixed material obtained from the sand-milling is cyclically mixed for 20-40 min, such as 20 min, 22 min, 24 min, 26 min, 28 min, 30 min, 32 min, 34 min, 36 min, 38 min or 40 min; however, the time is not limited to the listed values, other unlisted values within the range are also applicable; further optionally, the time is 30 min.

Optionally, a temperature of the spray prilling is 200-400°C, such as 200°C, 220°C, 240°C, 260°C, 280°C, 300°C, 320°C, 340°C, 360°C, 380°C or 400°C; however, the temperature is not limited to the listed values, other unlisted values within the range are also applicable.

As an optional technical solution of the present application, in step (II), a time of the second sand-milling is 100-150 min, such as 100 min, 105 min, 110 min, 115 min, 120 min, 125 min, 130 min, 135 min, 140 min, 145 min or 150 min; however, the time is not limited to the listed values, other unlisted values within the range are also applicable; optionally, the time is 120 min.

As an optional technical solution of the present application, in step (III), the PVA is 0.05-0.1wt% of a total mass of the sand-milling material, such as 0.05wt%, 0.06wt%, 0.07wt%, 0.08wt%, 0.09wt% or 0.1wt%; however, the mass fraction is not limited to the listed values, other unlisted values within the range are also applicable; optionally, the mass fraction is 0.08wt%.

Optionally, the defoamer is 0.001-0.005wt% of a total mass of the sand-milling material, such as 0.001wt%, 0.002wt%, 0.003wt%, 0.004wt% or 0.005wt%; however, the mass fraction is not limited to the listed values, other unlisted values within the range are also applicable; optionally, the mass fraction is 0.004wt%.

Optionally, the particles obtained from the second spray prilling have an average particle size of 50-200 µm, such as 50 µm, 60 µm, 70 µm, 80 µm, 90 µm, 100 µm, 110 µm, 120 µm, 130 µm, 140 µm, 150 µm, 160 µm, 170 µm, 180 µm, 190 µm or 200 µm; however, the average particle size is not limited to the listed values, other unlisted values within the range are also applicable.

Optionally, the blank has a density of 2.9-3.1 g/cm³, such as 2.9 g/cm³, 2.92 g/cm³, 2.94 g/cm³, 2.96 g/cm³, 2.98 g/cm³, 3.0 g/cm³, 3.02 g/cm³, 3.04 g/cm³, 3.06 g/cm³, 3.08 g/cm³ or 3.1 g/cm³; however, the density is not limited to the listed values, other unlisted values within the range are also applicable.

Optionally, the blank has a sheet structure, and the blank is provided with a through hole along the thickness direction at the center.

As an optional technical solution of the present application, in step (IV), the temperature-holding sintering includes:
heating the blank at a heating rate of V₁ from room temperature to T₁ in an air atmosphere, and holding the temperature for a period of time; subsequently, cooling the blank at a cooling rate of V₂ to T₂ in a protective atmosphere; finally, further cooling the blank at a cooling rate of V₃ to room temperature in a protective atmosphere.

The present application adopts a gradient sintering process, which is conducive to the discharge of glue and organic additives from the blank, uniform grain growth, and proper control of sintering costs.

Optionally, the air atmosphere has an oxygen volume concentration of 2-6%, such as 2.0%, 2.5%, 3.0%, 3.5%, 4.0%, 4.5%, 5.0%, 5.5% or 6.0%; however, the oxygen volume concentration is not limited to the listed values, other unlisted values within the range are also applicable.

Optionally, the V₁ is 0.3-2 °C/min, such as 0.3 °C/min, 0.4 °C/min, 0.5 °C/min, 0.6 °C/min, 0.7 °C/min, 0.8 °C/min, 0.9 °C/min, 1.0 °C/min, 1.1 °C/min, 1.2 °C/min, 1.3 °C/min, 1.4 °C/min, 1.5 °C/min, 1.6 °C/min, 1.7 °C/min, 1.8 °C/min, 1.9 °C/min or 2.0 °C/min; however, the V₁ is not limited to the listed values, other unlisted values within the range are also applicable.

Optionally, the T₁ is 1300-1450°C, such as 1300°C, 1310°C, 1320°C, 1330°C, 1340°C, 1350°C, 1360°C, 1370°C, 1380°C, 1390°C, 1400°C, 1410°C, 1420°C, 1430°C, 1440°C or 1450°C; however, the T₁ is not limited to the listed values, other unlisted values within the range are also applicable.

Optionally, the temperature of T₁ is held for 3-8 h, such as 3 h, 4 h, 5 h, 6 h, 7 h or 8 h; however, the time is not limited to the listed values, other unlisted values within the range are also applicable; further optionally, the time is 5 h.

Optionally, the protective atmosphere is a nitrogen atmosphere.

Optionally, the V₂ is 1.5-1.7 °C/min, such as 1.5 °C/min, 1.52 °C/min, 1.54 °C/min, 1.56 °C/min, 1.58 °C/min, 1.6 °C/min, 1.62 °C/min, 1.64 °C/min, 1.66 °C/min, 1.68 °C/min or 1.7 °C/min; however, the V₂ is not limited to the listed values, other unlisted values within the range are also applicable; further optionally, the V₂ is 1.67 °C/min.

Optionally, the T₂ is 800-1000°C, such as 800°C, 820°C, 840°C, 860°C, 880°C, 900°C, 920°C, 940°C, 960°C, 980°C or 1000°C; however, the T₂ is not limited to the listed values, other unlisted values within the range are also applicable; further optionally, the T₂ is 900°C.

Optionally, the V₃ is 1-5 °C/min, such as 1.0 °C/min, 1.5 °C/min, 2.0 °C/min, 2.5 °C/min, 3.0 °C/min, 3.5 °C/min, 4.0 °C/min, 4.5 °C/min or 5.0 °C/min; however, the V₃ is not limited to the listed values, other unlisted values within the range are also applicable; further optionally, the V₃ is 3 °C/min.

Compared with the prior art, the beneficial effects of the present application are as follows.

By peculiarly selecting each component in the main components and auxiliary components and optimizing the ratios in the present application, the overall performance of the prepared electromagnetic wave absorber is excellent, the magnetic permeability reaches 3500-6000 at 100 KHz and the reflection loss of the material significantly decreases, and meanwhile, the frequency range of the absorbed electromagnetic wave noise is extended.

### BRIEF DESCRIPTION OF DRAWINGS

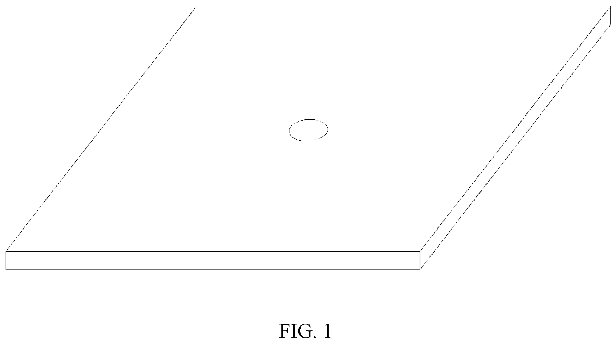

FIG. 1 is a structure diagram of an electromagnetic wave absorber prepared in Example 1 of the present application.

### DETAILED DESCRIPTION

The technical solutions of the present application are further described below with reference to the accompanying drawing and through the embodiments.

### Example 1

This example provides a preparation method of an electromagnetic wave absorber, and the preparation method includes the following steps.
(1) Calculated amounts of Fe₂O₃, Mn₃O₄ and ZnO were weighed according to molar percentages of each component in the main components as shown in Table 1 (MnO and Mn₃O₄ were equivalently converted by the molar percentage of Mn), and the materials were subjected to sand-milling with water added for 50 min, circulating mixing for 40 min subsequently and then spray prilling to obtain a spray material, in which the spray prilling was performed at 200°C.
(2) The spray material was pre-sintered and then subjected to second sand-milling with water added for 100 min to obtain a sand-milling material, in which the auxiliary components were added in specific ratios during the second sand-milling.
(3) The sand-milling material was added with PVA and a defoamer and then subjected to second spray prilling to obtain particles with an average particle size of 200 µm, in which the PVA was 0.05wt% of a total mass of the sand-milling material, and the defoamer was 0.001wt% of a total mass of the sand-milling material; the particles were molded to obtain a blank, in which the blank had a sheet structure as well as a density of 2.9-3.1 g/cm³, and was provided with a through hole along the thickness direction at the center.
(4) The blank was heated at a heating rate of 0.3 °C/min from room temperature to 1300°C in an air atmosphere with an oxygen volume concentration of 21%, and kept at 1300°C for 3 h; subsequently, the blank was cooled at a cooling rate of 1.5 °C/min to 800°C in a nitrogen atmosphere; finally, the blank was further cooled at a cooling rate of 1 °C/min to room temperature in a nitrogen atmosphere to obtain the electromagnetic wave absorber, in which as shown in FIG. 1, the prepared electromagnetic wave absorber had a sheet structure, and was provided with a through hole along the thickness direction at the center, and the thickness was 5.2 mm.

The prepared electromagnetic wave absorber was tested for magnetic permeability by the E4991 impedance analyzer at 25°C, 100 kHz and 0.25 mT; the prepared electromagnetic wave absorber was placed into the coaxial cavity and tested for reflection loss by 5232A in the frequency band of 25-300 MHz; the magnetic permeability, reflection loss and best matching frequency of the electromagnetic wave absorber are shown in Table 2.

### Example 2

(1) Calculated amounts of Fe₂O₃, Mn₃O₄ and ZnO were weighed according to molar percentages of each component in the main components as shown in Table 1 (MnO and Mn₃O₄ were equivalently converted by the molar percentage of Mn), and the materials were subjected to sand-milling with water added for 55 min, circulating mixing for 35 min subsequently and then spray prilling to obtain a spray material, in which the spray prilling was performed at 250°C.
(2) The spray material was pre-sintered and then subjected to second sand-milling with water added for 110 min to obtain a sand-milling material, in which the auxiliary components were added in specific ratios during the second sand-milling.
(3) The sand-milling material was added with PVA and a defoamer and then subjected to second spray prilling to obtain particles with an average particle size of 170 µm, in which the PVA was 0.06wt% of a total mass of the sand-milling material, and the defoamer was 0.003wt% of a total mass of the sand-milling material; the particles were molded to obtain a blank, in which the blank had a sheet structure and a density of 2.9-3.1 g/cm³.
(4) The blank was heated at a heating rate of 0.8 °C/min from room temperature to 1350°C in an air atmosphere with an oxygen volume concentration of 21%, and kept at 1350°C for 4 h; subsequently, the blank was cooled at a cooling rate of 1.6 °C/min to 850°C in a nitrogen atmosphere; finally, the blank was further cooled at a cooling rate of 2 °C/min to room temperature in a nitrogen atmosphere to obtain the electromagnetic wave absorber, in which as shown in FIG. 1, the prepared electromagnetic wave absorber had a sheet structure, and was provided with a through hole along the thickness direction at the center, and the thickness was 5.2 mm.

The prepared electromagnetic wave absorber was tested for magnetic permeability by the E4991 impedance analyzer at 25°C, 100 kHz and 0.25 mT; the prepared electromagnetic wave absorber was placed into the coaxial cavity and tested for reflection loss by 5232A in the frequency band of 25-300 MHz; the magnetic permeability, reflection loss and best matching frequency of the electromagnetic wave absorber are shown in Table 2.

### Example 3

(1) Calculated amounts of Fe₂O₃, Mn₃O₄ and ZnO were weighed according to molar percentages of each component in the main components as shown in Table 1 (MnO and Mn₃O₄ were equivalently converted by the molar percentage of Mn), and the materials were subjected to sand-milling with water added for 60 min, circulating mixing for 30 min subsequently and then spray prilling to obtain a spray material, in which the spray prilling was performed at 300°C.
(2) The spray material was pre-sintered and then subjected to second sand-milling with water added for 120 min to obtain a sand-milling material, in which the auxiliary components were added in specific ratios during the second sand-milling.
(3) The sand-milling material was added with PVA and a defoamer and then subjected to second spray prilling to obtain particles with an average particle size of 150 µm, in which the PVA was 0.08wt% of a total mass of the sand-milling material, and the defoamer was 0.004wt% of a total mass of the sand-milling material; the particles were molded to obtain a blank, in which the blank had a sheet structure as well as a density of 2.9-3.1 g/cm³.
(4) The blank was heated at a heating rate of 1.2 °C/min from room temperature to 1400°C in an air atmosphere with an oxygen volume concentration of 4%, and kept at 1400°C for 5 h; subsequently, the blank was cooled at a cooling rate of 1.67 °C/min to 900°C in a nitrogen atmosphere; finally, the blank was further cooled at a cooling rate of 3 °C/min to room temperature in a nitrogen atmosphere to obtain the electromagnetic wave absorber, in which as shown in FIG. 1, the prepared electromagnetic wave absorber had a sheet structure, and was provided with a through hole along the thickness direction at the center, and the thickness was 5.2 mm.

The prepared electromagnetic wave absorber was tested for magnetic permeability by the E4991 impedance analyzer at 25°C, 100 kHz and 0.25 mT; the prepared electromagnetic wave absorber was placed into the coaxial cavity and tested for reflection loss by 5232A in the frequency band of 25-300 MHz; the magnetic permeability, reflection loss and best matching frequency of the electromagnetic wave absorber are shown in Table 2.

### Example 4

(1) Calculated amounts of Fe₂O₃, Mn₃O₄ and ZnO were weighed according to molar percentages of each component in the main components as shown in Table 1 (MnO and Mn₃O₄ were equivalently converted by the molar percentage of Mn), and the materials were subjected to sand-milling with water added for 65 min, circulating mixing for 25 min subsequently and then spray prilling to obtain a spray material, in which the spray prilling was performed at 350°C.
(2) The spray material was pre-sintered and then subjected to second sand-milling with water added for 140 min to obtain a sand-milling material, in which the auxiliary components were added in specific ratios during the second sand-milling.
(3) The sand-milling material was added with PVA and a defoamer and then subjected to second spray prilling to obtain particles with an average particle size of 100 µm, in which the PVA was 0.09wt% of a total mass of the sand-milling material, and the defoamer was 0.004wt% of a total mass of the sand-milling material; the particles were molded to obtain a blank, in which the blank had a sheet structure as well as a density of 2.9-3.1 g/cm³.
(4) The blank was heated at a heating rate of 1.6 °C/min from room temperature to 1420°C in an air atmosphere with an oxygen volume concentration of 21%, and kept at 1420°C for 7 h; subsequently, the blank was cooled at a cooling rate of 1.68 °C/min to 950°C in a nitrogen atmosphere; finally, the blank was further cooled at a cooling rate of 4 °C/min to room temperature in a nitrogen atmosphere to obtain the electromagnetic wave absorber, in which as shown in FIG. 1, the prepared electromagnetic wave absorber had a sheet structure, and was provided with a through hole along the thickness direction at the center, and the thickness was 5.2 mm.

### Example 5

(1) Calculated amounts of Fe₂O₃, Mn₃O₄ and ZnO were weighed according to molar percentages of each component in the main components as shown in Table 1 (MnO and Mn₃O₄ were equivalently converted by the molar percentage of Mn), and the materials were subjected to sand-milling with water added for 70 min, circulating mixing for 20 min subsequently and then spray prilling to obtain a spray material, in which the spray prilling was performed at 400°C.
(2) The spray material was pre-sintered and then subjected to second sand-milling with water added for 150 min to obtain a sand-milling material, in which the auxiliary components were added in specific ratios during the second sand-milling.
(3) The sand-milling material was added with PVA and a defoamer and then subjected to second spray prilling to obtain particles with an average particle size of 50 µm, in which the PVA was 0.1wt% of a total mass of the sand-milling material, and the defoamer was 0.005wt% of a total mass of the sand-milling material; the particles were molded to obtain a blank, in which the blank had a sheet structure as well as a density of 2.9-3.1 g/cm³.
(4) The blank was heated at a heating rate of 2 °C/min from room temperature to 1450°C in an air atmosphere with an oxygen volume concentration of 21%, and kept at 1450°C for 8 h; subsequently, the blank was cooled at a cooling rate of 1.7 °C/min to 1000°C in a nitrogen atmosphere; finally, the blank was further cooled at a cooling rate of 5 °C/min to room temperature in a nitrogen atmosphere to obtain the electromagnetic wave absorber, in which as shown in FIG. 1, the prepared electromagnetic wave absorber had a sheet structure, and was provided with a through hole along the thickness direction at the center, and the thickness was 5.2 mm.

### Comparative Example 1

This comparative example differs from Example 5 in that the content of CuO in the auxiliary components was adjusted to 3.5wt%. The contents of each component in the main components and auxiliary components are shown in Table 1, and the process steps and operating parameters are exactly the same as in Example 1.

### Comparative Example 2

This comparative example differs from Example 5 in that the content of NiO in the auxiliary components was adjusted to 0.15wt%. The contents of each component in the main components and auxiliary components are shown in Table 1, and the process steps and operating parameters are exactly the same as in Example 1.

### Comparative Example 3

This comparative example differs from Example 5 in that the content of Co₂O₃ in the auxiliary components was adjusted to 1.5wt%. The contents of each component in the main components and auxiliary components are shown in Table 1, and the process steps and operating parameters are exactly the same as in Example 1.

### Comparative Example 4

This comparative example differs from Example 5 in that no CuO but only NiO and Co₂O₃ were added in the auxiliary components. The contents of each component in the main components and auxiliary components are shown in Table 1, and other process steps and operating parameters are exactly the same as in Example 1.

### Comparative Example 5

This comparative example differs from Example 5 in that no NiO but only CuO and Co₂O₃ were added in the auxiliary components. The contents of each component in the main components and auxiliary components are shown in Table 1, and other process steps and operating parameters are exactly the same as in Example 1.

### Comparative Example 6

This comparative example differs from Example 5 in that no Co₂O₃ but only CuO and NiO were added in the auxiliary components. The contents of CuO and NiO, and other process steps and operating parameters are exactly the same as in Example 1.

### Comparative Example 7

This comparative example differs from Example 5 in that no NiO nor Co₂O₃ but only CuO was added in the auxiliary components. The contents of each component in the main components and auxiliary components are shown in Table 1, and other process steps and operating parameters are exactly the same as in Example 1.

### Comparative Example 8

This comparative example differs from Example 5 in that no CuO nor Co₂O₃ but only NiO was added in the auxiliary components. The contents of each component in the main components and auxiliary components are shown in Table 1, and other process steps and operating parameters are exactly the same as in Example 1.

### Comparative Example 9

This comparative example differs from Example 5 in that no CuO nor NiO but only Co₂O₃ was added in the auxiliary components. The content of Co₂O₃, and other process steps and operating parameters are exactly the same as in Example 1.

### Comparative Example 10

This comparative example is Example 1 disclosed in CN110845228A, which specifically includes the following steps.
(1) Fe₂O₃, Mn₃O₄ and ZnO (Fe₂O₃, Mn₃O₄ and ZnO had molar percentages of 47 mol%, 29 mol% and 24 mol%, respectively, in which MnO and Mn₃O₄ were equivalently converted by the molar percentage of Mn) were prepared as the main components, and TiO₂, SnO₂, Na₂O (in the form of Na₂CO₃) and Ta₂O₅ were prepared as the auxiliary components; the main components and the auxiliary components were weighed according to Table 1, wet mixed in a sand mill for 0.5 h, dried and pre-sintered at 900°C for 2 h in air to obtain a pre-sintered material.
(2) The pre-sintered material was sand-milled in a sand mill for 2 hours, dried (the dried pre-sintered material being 100wt%) and added with 1.0wt% polyvinyl alcohol (commercially available) as a bonding agent for prilling, molding and sintering to finally obtain a circular blank with an outer diameter of 7.0 mm, an inner diameter of 3.0 mm and a height of 10.0 mm.
(3) The blank was sintered at 1300°C with a temperature-holding time of 5 hours.

The electromagnetic wave absorbers prepared in Examples 1-5 and Comparative Examples 1-10 were subjected to performance tests. The prepared electromagnetic wave absorbers were tested for magnetic permeability by the E4991 impedance analyzer at 25°C, 100 kHz and 0.25 mT; the prepared electromagnetic wave absorbers were placed into the coaxial cavity and tested for reflection loss by 5232A in the frequency band of 25-300 MHz; the magnetic permeability and reflection loss of the electromagnetic wave absorbers are shown in Table 2.

**Table 1**

| | Main Component | | | Auxiliary Component | | |
|---|---|---|---|---|---|---|
| | Fe₂O₃ | ZnO | MnO | CuO | NiO | Co₂O₃ |
| Example 1 | 44 | 20 | 36 | 0.5 | 0.01 | 0.1 |
| Example 2 | 44.5 | 21 | 34.5 | 1 | 0.03 | 0.3 |
| Example 3 | 45 | 22 | 33 | 2 | 0.05 | 0.5 |
| Example 4 | 45.5 | 23 | 31.5 | 2.5 | 0.07 | 0.7 |
| Example 5 | 46 | 24 | 30 | 3 | 0.1 | 1 |
| Comparative Example 1 | 44 | 20 | 36 | 3.5 | 0.1 | 1 |
| Comparative Example 2 | 46 | 24 | 30 | 3 | 0.15 | 1 |
| Comparative Example 3 | 46 | 24 | 30 | 3 | 0.1 | 1.5 |
| Comparative Example 4 | 46 | 24 | 30 | - | 0.1 | 1 |
| Comparative Example 5 | 46 | 24 | 30 | 3 | - | 1 |
| Comparative Example 6 | 46 | 24 | 30 | 3 | 0.1 | - |
| Comparative | 46 | 24 | 30 | 3 | - | - |
| Example 7 | | | | | | |
| Comparative Example 8 | 46 | 24 | 30 | - | 0.1 | - |
| Comparative Example 9 | 46 | 24 | 30 | - | - | 1 |

**Table 2**

| | Magnetic Permeability | Maximum Reflection Loss |
|---|---|---|
| Example 1 | 3583 | -26 dB |
| Example 2 | 4210 | -28 dB |
| Example 3 | 5084 | -35 dB |
| Example 4 | 5430 | -32 dB |
| Example 5 | 3872 | -25 dB |
| Comparative Example 1 | 2890 | -18 dB |
| Comparative Example 2 | 2917 | -20 dB |
| Comparative Example 3 | 2430 | -18 dB |
| Comparative Example 4 | 2257 | -19 dB |
| Comparative Example 5 | 3243 | -22 dB |
| Comparative Example 6 | 3618 | -20 dB |
| Comparative Example 7 | 3420 | -17 dB |
| Comparative Example 8 | 2109 | -15 dB |
| Comparative Example 9 | 2044 | -18 dB |
| Comparative Example 10 | 3520 | -22 dB |

As can be seen from the test results provided in Table 2:
(1) It can be seen from Examples 1-5 that with the formulation in the appropriate range, the magnetic permeability of the material reaches ideal value, the electromagnetic wave absorption rate of the product is large, and the insertion loss is less than -24 dB.
(2) It can be seen from the comparison between the test results from Example 1 and Comparative Example 1 that when the CuO addition is greater than 3%, the magnetic permeability of the material decreases and the insertion loss increases, which is resulted from the fact that the excessive CuO addition leads to overbuming of the material and abnormal grain growth.
(3) It can be seen from the comparison between the test results from Example 5 and Comparative Examples 2-3 that when the NiO and Co₂O₃ additions exceed the disclosed range of the present application, the magnetic permeability of the material decreases significantly, and the insertion loss increases at the same time, which is resulted from the fact that both Ni and Co enter the lattice during the sintering process and replace the original ions in their positions, thus reducing the magnetic permeability.
(4) It can be seen from the comparison between the test results from Example 5 and Comparative Examples 4-9 that when one or two of CuO, NiO and Co₂O₃ are not added in the material, the magnetic permeability or insertion loss of the material does not reach the desired effect, or both magnetic permeability and insertion loss do not reach the desired effect, which is resulted from the fact that these three additives not only have their own effect when added separately, but also have synergetic effect among them, and the combined addition has better effect on the characteristics of the material.
(5) It can be seen from Comparative Example 10 that although the magnetic permeability can reach more than 3000, the insertion loss is high and the electromagnetic wave absorption effect is poor.

The applicant has stated that although the specific embodiments of the present application are described above, the protection scope of the present application is not limited to the embodiments.

## Claims

1. A ferrite material for electromagnetic wave absorption and shielding, which comprises main components and auxiliary components; the main components comprise Fe₂O₃, ZnO and MnO, and the auxiliary components comprise CuO, NiO and Co₂O₃.

2. The ferrite material according to claim 1, wherein based on a molar percentage of the main components being 100mol%, Fe₂O₃ is 44-46mol%, ZnO is 20-24mol%, and the remainder is MnO.

3. The ferrite material according to claim 1, wherein based on a mass fraction of the main components being 100wt%, the auxiliary components comprise 0-3wt% of CuO, 0-0.1wt% of NiO, and 0-1wt% of Co₂O₃, and the contents of CuO, NiO and Co₂O₃ do not include 0.

4. An electromagnetic wave absorber, which is prepared from the ferrite material according to any one of claims 1 to 3.

5. The electromagnetic wave absorber according to claim 4, wherein the electromagnetic wave absorber has a magnetic permeability of 3500-6000 at 25°C, 100 kHz and 0.25 mT test conditions;
optionally, the electromagnetic wave absorber has a maximum reflection loss of -24 dB in the frequency band of 25-300 MHz;
optionally, the electromagnetic wave absorber has a best matching frequency of 25-50 MHz;
optionally, the electromagnetic wave absorber has a sheet structure, and the electromagnetic wave absorber is provided with a through hole along the thickness direction at the center;
optionally, the electromagnetic wave absorber has a thickness of 3-10 mm.

6. A preparation method of the electromagnetic wave absorber according to claim 4 or 5, which comprises:
weighing calculated amounts of Fe₂O₃, Mn₃O₄ and ZnO according to molar percentages of each component in the main components, mixing the main components with the auxiliary components including CuO, NiO and Co₂O₃ and performing prilling and molding to obtain a blank, and subjecting the blank to temperature-holding sintering to obtain the electromagnetic wave absorber.

7. The preparation method according to claim 6, wherein the preparation method specifically comprises the following steps:
(I) weighing calculated amounts of Fe₂O₃, Mn₃O₄ and ZnO according to molar percentages of each component in the main components, performing sand-milling with water added, and performing spray prilling to obtain a spray material;
(II) pre-sintering the spray material, and performing second sand-milling with water added to obtain a sand-milling material, wherein the auxiliary components are added in specific ratios during the second sand-milling;
(III) adding PVA and a defoamer to the sand-milling material, performing second spray prilling to obtain particles, and molding the particles to obtain a blank;
(IV) subjecting the blank to temperature-holding sintering to obtain the electromagnetic wave absorber.

8. The preparation method according to claim 7, wherein, in step (I), a time of the sand-milling is 50-70 min, optionally 60 min;
optionally, before subjected to the spray prilling, a mixed material obtained from the sand-milling is cyclically mixed for 20-40 min, optionally 30 min;
optionally, a temperature of the spray prilling is 200-400°C.

9. The preparation method according to claim 7 or 8, wherein, in step (II), a time of the second sand-milling is 100-150 min, optionally 120 min.

10. The preparation method according to any one of claims 7 to 9, wherein, in step (III), the PVA is 0.05-0.1wt% of a total mass of the sand-milling material, optionally 0.08wt%;
optionally, the defoamer is 0.001-0.005wt% of a total mass of the sand-milling material, optionally 004wt%;
optionally, the particles obtained from the second spray prilling have an average particle size of 50-200 µm;
optionally, the blank has a density of 2.9-3.1 g/cm³;
optionally, the blank has a sheet structure, and the blank is provided with a through hole along the thickness direction at the center.

11. The preparation method according to any one of claims 7 to 10, wherein, in step (IV), the temperature-holding sintering comprises:
heating the blank at a heating rate of V₁ from room temperature to T₁ in an air atmosphere, and holding the temperature for a period of time; subsequently, cooling the blank at a cooling rate of V₂ to T₂ in a protective atmosphere; finally, further cooling the blank at a cooling rate of V₃ to room temperature in a protective atmosphere;
optionally, the air atmosphere has an oxygen volume concentration of 2-6%;
optionally, the V₁ is 0.3-2 °C/min;
optionally, the T₁ is 1300-1450°C;
optionally, the temperature of T₁ is held for 3-8 h, optionally 5 h;
optionally, the protective atmosphere is a nitrogen atmosphere;
optionally, the V₂ is 1.5-1.7 °C/min, optionally 1.67 °C/min;
optionally, the T₂ is 800-1000°C, optionally 900°C;
optionally, the V₃ is 1-5 °C/min, optionally 3 °C/min.
